# EUROPEAN PATENT APPLICATION

(11) **EP 1 871 091 A2**
(43) Date of publication of application: **26.12.2007**
(21) Application number: 07109490.8
(22) Date of filing: 04.06.2007
(51) Int. Cl.: H04N 3/15, H04N 9/04

(54) **Camera Module**

(30) Priority: 19.06.2006 KR 20060055024
(71) Applicant: Samsung Electro-Mechanics Co., Ltd., Suwon-si, Gyeonggi-do (KR)
(72) Inventor: Sung, Gee-young, Yongin-si Gyeonggi-do (KR); Park, Du-sik, Yongin-si Gyeonggi-do (KR); Lee, Ho-young, Yongin-si Gyeonggi-do (KR); Kim, Sung-su, Yongin-si Gyeonggi-do (KR); Kim, Chang-yeong, Yongin-si Gyeonggi-do (KR)
(74) Representative: Grünecker, Kinkeldey, Stockmair & Schwanhäusser Anwaltssozietät

(57) **Abstract**

Provided is a camera module having a wide dynamic range (WDR) function and a reduced size. The camera module includes a lens unit including a plurality of lenses collecting incident light; a filter unit having a plurality of filtering regions corresponding to respective regions of the lenses; and an image sensor unit having a plurality of sensing regions, each converting light that passes through each of the filtering regions into an electrical signal. The filtering regions are divided into a first filtering region in which different color filters are formed and a second filtering region in which a color filter having a higher transmittance than the transmittances of the color filters formed in the first filtering region is formed.

## Description

### CROSS-REFERENCE TO RELATED APPLICATIONS

This application claims priority from Korean Patent Application No. 10-2006-0055024 filed on June 19, 2006 in the Korean Intellectual Property Office, the disclosure of which is incorporated herein by reference in its entirety.

### BACKGROUND OF THE INVENTION

### 1. Field of the Invention

The present invention relates to a camera module, and more particularly, to a camera module having a wide dynamic range (WDR) function and a reduced size.

### 2. Description of the Related Art

Digital devices including high-resolution camera modules, such as digital cameras and camera phones, have been widely used. Generally, a camera module includes a lens and an image sensor. The lens collects light reflected from a subject, and the image sensor detects the light collected by the lens and converts the detected light into an electrical image signal. Image sensors are largely classified into camera tubes and solid-state image sensors. Typical examples of the solid-state image sensors include charge coupled devices (CCDs) and metal oxide silicons (MOSes).

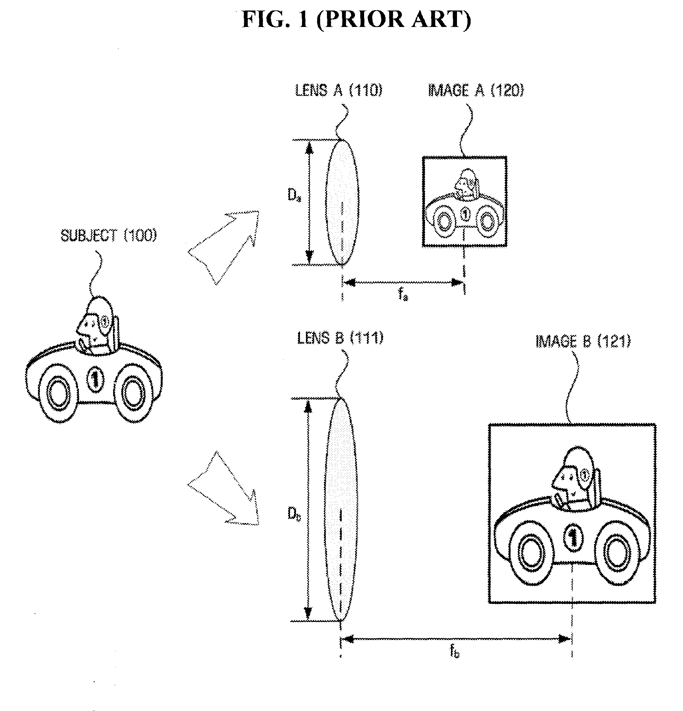

FIG. 1 is a diagram for explaining the principle of a conventional camera module. In the conventional camera module, the higher the aperture ratio, the brighter the image that is obtained. In addition, the greater the F number (F/#), the clearer the image that is obtained. The aperture ratio denotes a value obtained after an aperture of a lens is divided by a focal distance f, that is, D/f. The brightness of an image is proportional to the square of the aperture ratio. The F number denotes the reciprocal of the aperture ratio, that is, f/D. As the F number increases, the amount of light reaching an image sensor of the camera module per unit area decreases. Conversely, as the F number decreases, the amount of light reaching the image sensor per unit area increases, and thus a bright image can be obtained.

As illustrated in FIG. 1, a greater aperture of a lens enhances resolution but increases a focal distance for forming an image of a subject. Therefore, there is a limitation on reducing the size of the conventional camera module.

There have been continuous efforts to create wide dynamic range (WDR) images. The WDR, which is a more advanced technology than conventional backlight compensation, enables a user to obtain an image just like what the user sees with his or her eyes when the user takes a photograph in a bright or dark place.

To this end, a conventional technology for additionally implementing a low-sensitivity sensing region and a high-sensitivity sensing region, which is more sensitive to light than the low-sensitivity sensing region, in an image sensor, and changing the structures of the high- and low-sensitivity sensing regions to sense more light, have been suggested.

However, according to this conventional technology, the structures of the high- and low-sensing regions are complicated, and a new processing technology is required following changes in the structures of the high- and low-sensing regions.

To solve these problems, various inventions (for example, Korean Patent Publication No. 2003-0084343, entitled "Method of Manufacturing CMOS Image Sensor to Secure Focal Distance") have been suggested. However, these inventions have failed to solve the above problems.

### SUMMARY OF THE INVENTION

Accordingly, it is an aspect of the present invention to provide a camera module having a reduced size and a wide dynamic range (WDR) function without requiring a new processing technology.

Additional aspects and/or advantages of the invention will be set forth in part in the description which follows and, in part, will be apparent from the description, or may be learned by practice of the invention.

The foregoing and/or other aspects are achieved by providing a camera module. The camera module includes a lens unit including a plurality of lenses collecting incident light; a filter unit having a plurality of filtering regions corresponding to respective regions of the lenses; and an image sensor unit having a plurality of sensing regions, each converting light that passes through each of the filtering regions into an electrical signal, wherein each of the filtering regions is divided into a first filtering region in which different color filters are formed and a second filtering region in which a color filter having a higher transmittance than the transmittances of the color filters formed in the first filtering region is formed.

The foregoing and/or other aspects are achieved by providing a camera module. The camera module includes a lens unit including a plurality of lenses having different colors and collecting incident light; and an image sensor unit having a plurality of sensing regions, each converting light that passes through each of the lenses into an electrical signal.

### BRIEF DESCRIPTION OF THE DRAWINGS

These and/or other aspects and advantages of the invention will become apparent and more readily appreciated from the following description of the embodiments, taken in conjunction with the accompanying drawings of which:
FIG. 1 is a diagram for explaining the principle of a conventional camera module;
FIG. 2 is a perspective view of a camera module according to an embodiment of the present invention;
FIGS. 3A through 3C illustrate the structure of a filter unit illustrated in FIG. 2 according to various embodiments of the present invention;
FIG. 4 is a plan view for explaining a process of manufacturing the filter unit illustrated in FIG. 3C according to an embodiment of the present invention;
FIG. 5 is a cross-sectional view of a unit pixel of an image sensor unit illustrated in FIG. 2 according to an embodiment of the present invention;
FIGS. 6A and 6B illustrate the amount that light slantingly incident on a micro-lens illustrated in FIG. 5 converges a light-receiving device according to the distance between the micro-lens and the light-receiving device;
FIGS. 7A and 7B are diagrams for explaining a method of restoring an image according to an embodiment of the present invention; and
FIG. 8 is a perspective view of a camera module according to another embodiment of the present invention.

### DETAILED DESCRIPTION OF THE PREFERRED EMBODIMENTS

Reference will now be made in detail to the embodiments of the present invention, examples of which are illustrated in the accompanying drawings, wherein like reference numerals refer to the like elements throughout. The embodiments are described below to explain the present invention by referring to the figures.

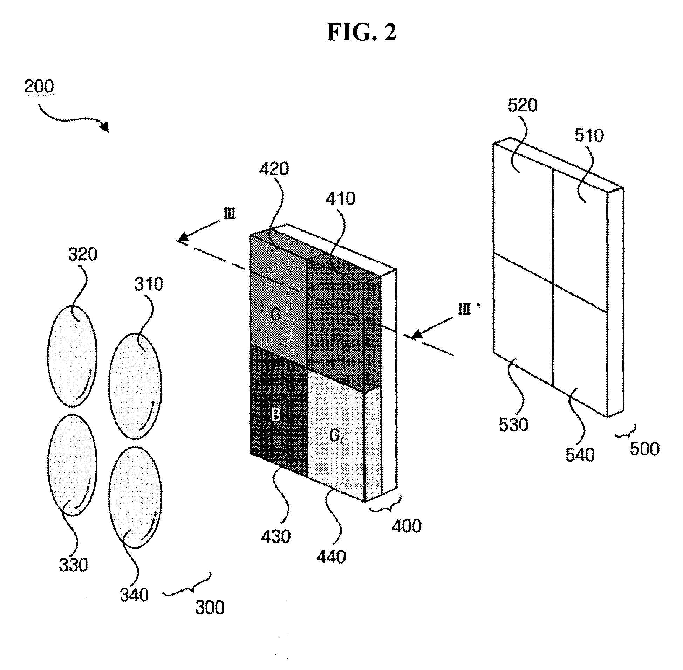

FIG. 2 is a perspective view of a camera module 200 according to an embodiment of the present invention. Referring to FIG. 2, the camera module 200 includes a lens unit 300, a filter unit 400, and an image sensor unit 500.

The lens unit 300 may include a plurality of lenses 310 through 340 collecting incident light. In this case, the number of lenses is not limited, and the lenses 310 through 340 may be arranged in various forms on the same plane. For example, the lenses 310 through 340 may be arranged in a row or column or in a matrix with rows and columns. For convenience, the present embodiment will hereinafter be described on the assumption that the lens unit 300 includes four lenses arranged in a 2X2 matrix.

The filter unit 400 filters the light collected by the lenses 310 through 340 and thus implements an original primary color. To this end, the filter unit 400 may have a filtering region that includes a plurality of sub-filtering regions corresponding to the lenses 310 through 340 and having different color filters. For example, if the lens unit 300 includes four lenses arranged in a 2x2 matrix as described above, the filter unit 400 includes first through fourth sub-filtering regions 410 through 440.

In addition, the filtering region may be divided into a first filtering region including the first through third sub-filtering regions 410 through 430 and a second filtering region including the fourth sub-filtering region 440 according to the transmittance of a color filter formed in each of the first through fourth sub-filtering regions 410 through 440. In this case, the first filtering region may include a plurality of sub-filtering regions, and the second filtering region may include a single sub-filtering region.

According to the present embodiment, a color filter formed in a sub-filtering region included in the second filtering region may have a higher transmittance than that of a color filter formed in a sub-filtering region included in the first filtering region. For example, red, green and blue color filters may respectively be formed in the first through third sub-filtering regions 410 through 430 included in the first filtering region, and, for example, a gray color filter, which has a higher transmittance than those of the red, green and blue color filters, may be formed in the fourth sub-filtering region 440 included in the second filtering region. In this example, transmittance increases in order of the blue, red, and green color filters, and the gray color filter has a higher transmittance than that of the green color filter.

In another embodiment of the present invention, a color filter other than the gray color filter may be formed in the fourth sub-filtering region 440. For example, any one of white or no color, yellow, cyan, and magenta color filters may be formed. The color of the color filter formed in the fourth sub-filtering region 440 may not be restricted to the above colors. Any color filter having a higher transmittance than that of a color filter formed in a sub-filtering region of the first filter region may be construed as being within the scope of the embodiments of the present invention.

If a color filter is formed in each sub-filtering region as described above, a difference in the amount of light passing through each sub-filtering region is created. In other words, there is a difference in the amount of light reaching each of a plurality of sub-sensing regions of the image sensor unit 500, which will be described in detail later Such a difference indicates that a high-sensitivity sensing function and a low-sensitivity sensing function can be simultaneously implemented in the image sensor unit 500.

Specifically, a sensing region of the image sensor unit 500 may be divided into first through fourth sub-sensing regions 510 through 540 corresponding to the first through fourth sub-filtering regions 410 through 440, respectively. Here, the amount of light reaching a sub-sensing region corresponding to a sub-filtering region included in the second filtering region is greater than that of light reaching a sub-sensing region corresponding to a sub-filtering region included in the first filtering region. Hence, it can be understood that the sub-sensing region corresponding to the sub-filtering region included in the second filtering region has a relatively high-sensitivity sensing function as compared to the sub-sensing region corresponding to the sub-filtering region included in the first filtering region.

More specifically, in the above example, the sensing region of the image sensor unit 500 is divided into the first through fourth sub-sensing regions 510 through 540 corresponding to the first through fourth sub-filtering regions 410 through 440, respectively. In this case, the amount of light reaching the fourth sub-sensing region 540 is greater than that of light reaching the first sub-sensing region 510. That is because the gray color filter is formed in the fourth sub-filtering region 440 corresponding to the fourth sub-sensing region 540, and the red color filter having a lower transmittance than that of the gray color filter is formed in the first sub-filtering region 410 corresponding to the first sub-sensing region 510. Hence, the fourth sub-sensing region 540 has a higher-sensitivity sensing function than that of the first sub-sensing region 510. Similarly, the amount of light reaching each of the second and third sub-sensing regions 520 and 530 is less than that of light reaching the fourth sub-sensing region 540. Therefore, the second and third sub-sensing regions 520 and 530 have a lower-sensitivity sensing function than that of the fourth sub-sensing region 540.

In addition to the components described above, the filter unit 400 may selectively include a filter that filters light having a predetermined wavelength. For example, the filter unit 400 may further include an infrared filter 460. The infrared filter 460 filters infrared light reaching an image sensor, thereby preventing image information in a visible light region from being damaged. In other words, the sensitivity of the image sensor responds to the infrared light. Therefore, if the infrared filter 460 is used, since the infrared light can be filtered, the damage to the image information in the visible light region can be prevented. In the structure of a conventional image sensor, a color filter and an infrared filter cannot be integrated. However, according to the embodiments of the present invention, a color filter and the infrared filter 460 can be integrated.

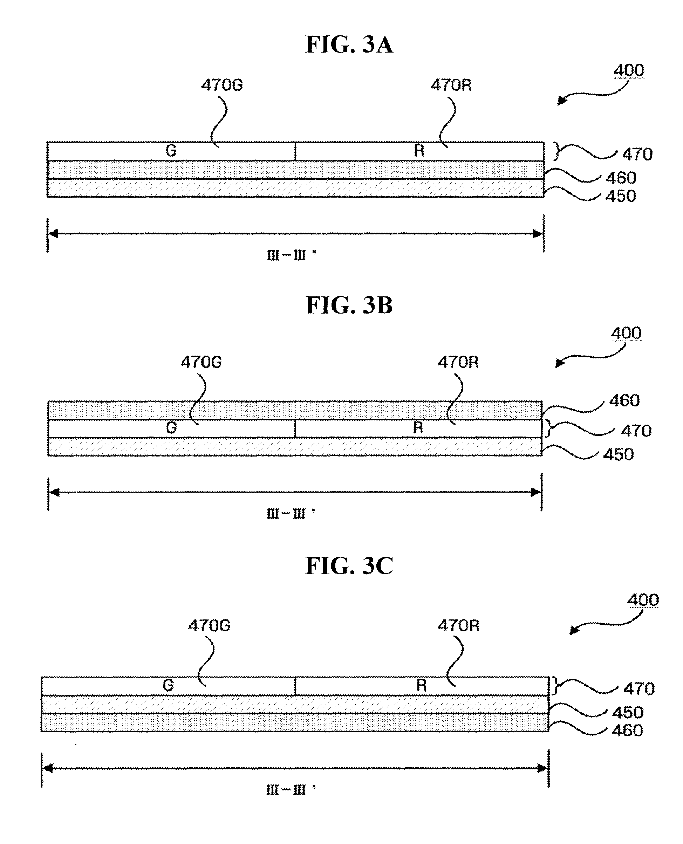

The infrared filter 460 may be formed between a substrate 450 (see FIG. 3A) and a color filter layer 470 (see FIG. 3A) or may be formed on the color filter layer 470. Alternatively, if the color filter layer 470 is formed on a surface of the substrate 450, the infrared filter 460 may be formed on the other surface of the substrate 450. FIGS. 3A though 3C are cross-sectional views of the filter unit 400 taken along a line III-III' of FIG. 2. FIGS. 3A through 3C illustrate the disposition of a color filter and an infrared filter 460 according to various embodiments of the present invention. Referring to FIG. 3A, the infrared filter 460 and the color filter layer 470 formed of color filters are sequentially formed on a surface of the substrate 450. Referring to FIG. 3B, the color filter layer 470 formed of color filters and the infrared filter 460 are sequentially formed on a surface of the substrate 450. Referring to FIG. 3C, the color filter layer 470 formed of color filters is formed on a surface of the substrate 450, and the infrared filter 460 is formed on the other surface of the substrate 450.

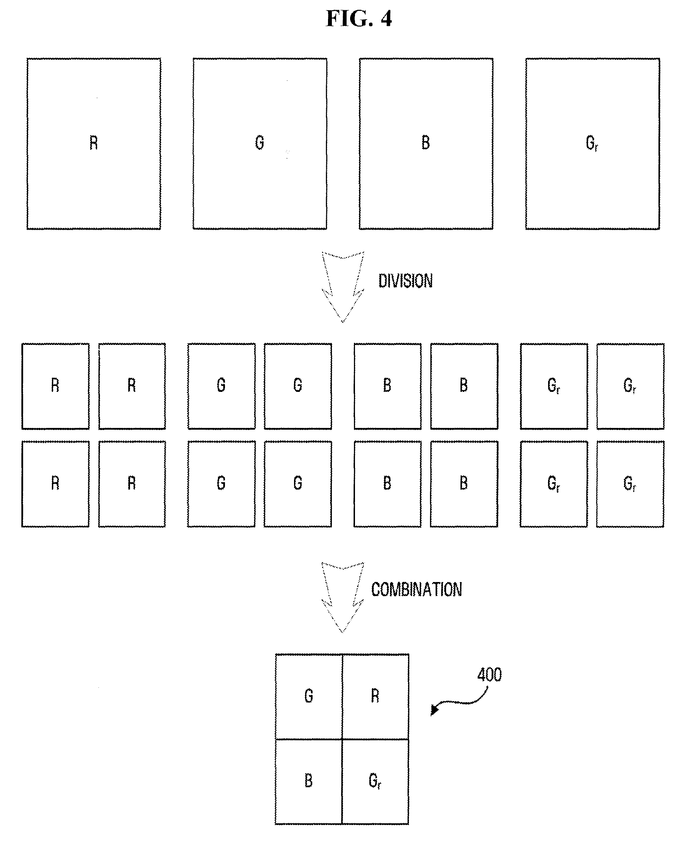

The filter unit 400 may be formed after each of a plurality of substrates, on which different color filters are formed, which are divided into a plurality of sub-substrates and then the sub-substrates having different color filters are combined. FIG. 4 is a plan view for explaining a process of manufacturing the filter unit 400 according to an embodiment of the present invention. To form the filter unit 400 structured as illustrated in, for example, FIG. 3C, the infrared filter 460 is formed on a surface of each of first through fourth substrates. Then, red (470R), green (470G), blue and gray color filters are coated on the other surface of each of the first through fourth substrates to form the color filter layer 470. Next, each of the first through fourth substrates is divided into four sub-substrates. Finally, the sub-substrates having different color filters are combined. In the above process, a process of patterning the color filters is omitted, thereby saving ink used to create the color filters.

The image sensor unit 500 senses light passing through each of the first through fourth sub-filtering regions 410 through 440 and converts the sensed light into an electrical signal. To this end, the image sensor unit 500 includes an optical sensing unit (not shown) sensing light that passes through each of the first through fourth sub-filtering regions 410 through 440 and a circuit unit (not shown) converting the light sensed by the optical sensing unit into an electrical signal and then into data.

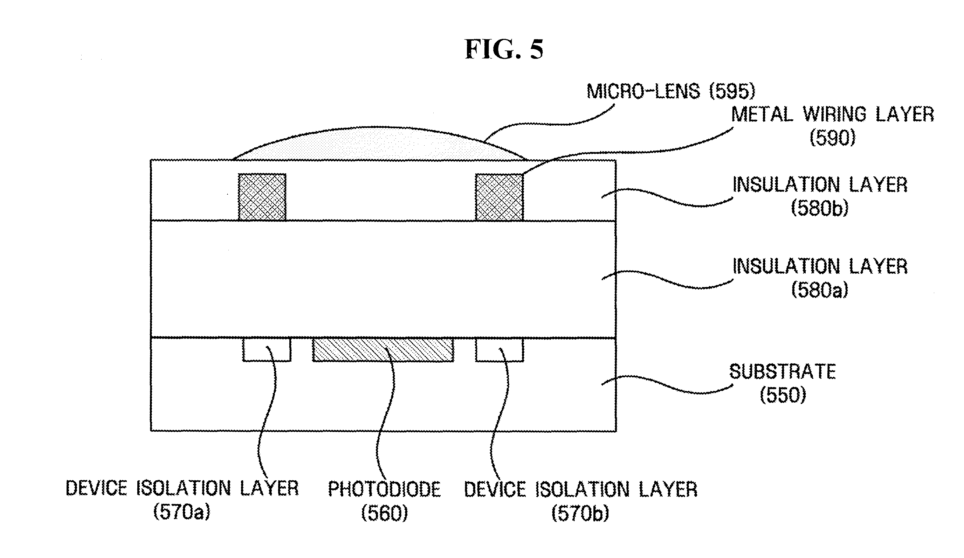

Hereinafter, the image sensor unit 500 will be described in more detail with reference to FIG. 5. FIG. 5 is a cross-sectional view of a unit pixel of the image sensor unit 500 according to an embodiment of the present invention.

Referring to FIG. 5, a light-receiving device, e.g., a photodiode 560, is formed on a substrate 550. Device isolation layers 570a, 570b are formed between the light-receiving devices 560.

A metal wiring layer 590 creating the circuit unit is formed on the light-receiving device 560. An insulation layer 580a, i.e., an inter-metal dielectric layer, is formed between the light-receiving device 560 and the metal wiring layer 590. The metal wiring layer 590 may be designed not to block a path of light incident on the light-receiving device 560. In FIG. 5, the metal wiring layer 590 is formed of a single layer. However, the metal wiring layer 590 may be formed of a plurality of layers if necessary. Each metal wiring layer 590 is covered by an insulation layer 580b insulating each metal wiring layer 590.

A micro-lens 595 increasing optical sensitivity is formed on top of the insulation layer 580b. Generally, the photodiode 560 occupies only a portion of the unit pixel. Therefore, a fill factor indicating a proportion of the unit pixel occupied by the photodiode 560 is less than 1. If the fill factor is less than 1, it denotes than some of incident light is lost. However, if the micro-lens 595 is formed on top of the insulation layer 580b, since the incident light is collected by the micro-lens 595, the amount of light converged on the light-receiving device, i.e., the photodiode 560, can be increased.

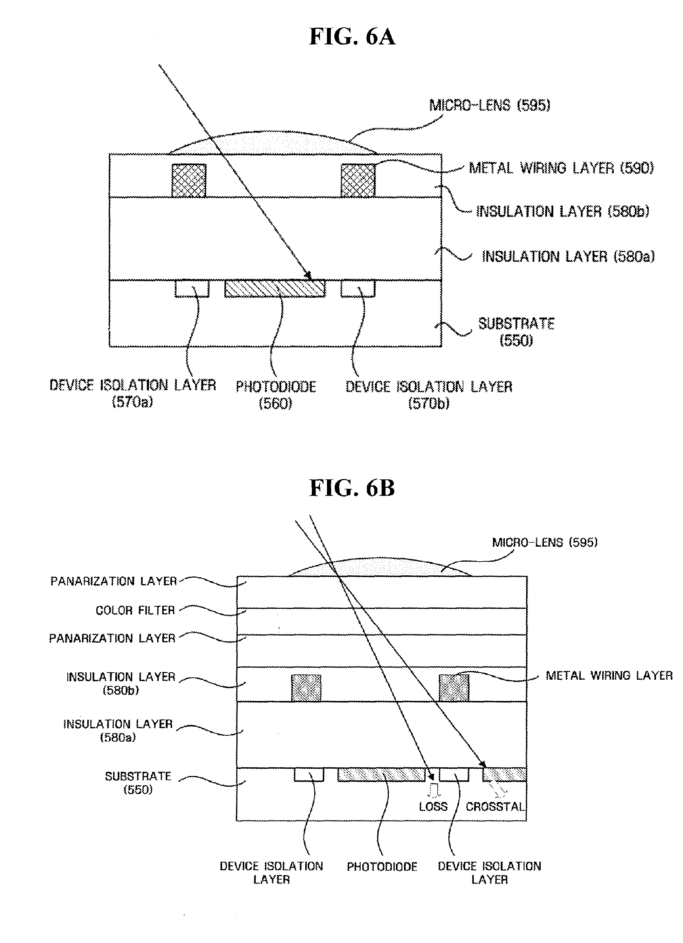

Unlike a conventional image sensor, the image sensor unit 500 described above does not include the color filter layer 470 and a planarization layer (see FIG. 6B) for planarizing the color filter layer 470. Therefore, an optical loss and crosstalk can be reduced, which will now be described in more detail with reference to FIGS. 6A and 6B.

FIGS. 6A and 6B illustrate the amount that light slantingly incident on a micro-lens 595 converges on a light-receiving device according to the distance between the micro-lens and the light-receiving device. Specifically, FIG. 6A is a cross-sectional view of a unit pixel of an image sensor according to an embodiment of the present invention, and FIG. 6B is a cross-sectional view of a unit pixel of a conventional image sensor.

Referring to FIG. 6B, a focal position of a micro-lens is generally fixed to the position of the light-receiving device 560. In this case, all light perpendicularly incident on the micro-lens converges on the light-receiving device. However, not all light slantingly incident on the micro-lens at a certain angle converges on the light-receiving unit of the unit pixel. Some of the light is lost or incident on a light-receiving device of an adjacent pixel, thereby causing crosstalk. However, if a color filter layer and the planarization layer are removed from the conventional image sensor according to the embodiment of the present invention, the distance between the micro-lens and the light-receiving device is reduced. Therefore, light slantingly incident on a micro-lens at a certain angle converges on a light-receiving device, i.e., a photodiode 560, of the unit pixel as illustrated in FIG. 6A. Consequently, the amount of light incident on a light-receiving device of an adjacent pixel and crosstalk are reduced.

A plurality of pixels structured as described above form a sensing region. The sensing region may be divided into a plurality of sub-sensing regions respectively corresponding to a plurality of sub-filtering regions of the filter unit 400 described above. In other words, according to the above example, the sensing region of the image sensor unit 500 may be divided into the first through fourth sub-sensing regions 510 through 540 respectively corresponding to the first through fourth sub-filtering regions 410 through 440. The first through fourth sub-sensing regions 510 through 540 sense light that passes through the red, green, blue and gray color filters, respectively.

The sensing region divided into a plurality of sub-sensing regions may also be divided into low- and high-sensitivity sensing regions according to optical sensitivity. Each sub-sensing region is determined to be either the low-sensitivity sensing region or the high-sensitivity sensing region based on the amount of light reaching the sub-sensing region. The amount of light reaching each sub-sensing region varies according to a color filter formed in a sub-filtering region corresponding to the sub-sensing region. Therefore, sub-sensing regions respectively corresponding to the first filtering region may be determined to be the low-sensitivity sensing regions and the second filtering region may be determined to be the high-sensitivity sensing regions.

More specifically, in the above example, the first through third sub-sensing regions 510 through 530 are low-sensitivity sensing regions, and the fourth sub-sensing region 540 is a high-sensitivity sensing region. That is because the gray color filter formed in the fourth sub-filtering region 440 has a higher transmittance than those of the red, green and blue color filters formed in the first through third sub-filtering regions 410 through 430, respectively, and thus the amount of light reaching the fourth sub-sensing region 540 is greater than that of light reaching the first through third sub-sensing regions 510 through 530.

Once the high- and low-sensitivity sensing regions are formed in the image sensor unit 500 as described above, an image can be restored using luminance information obtained from each sensing region. Therefore, a clear image can be obtained in an environment having a large illuminance difference. In other words, a wide dynamic range (WDR) function can be implemented.

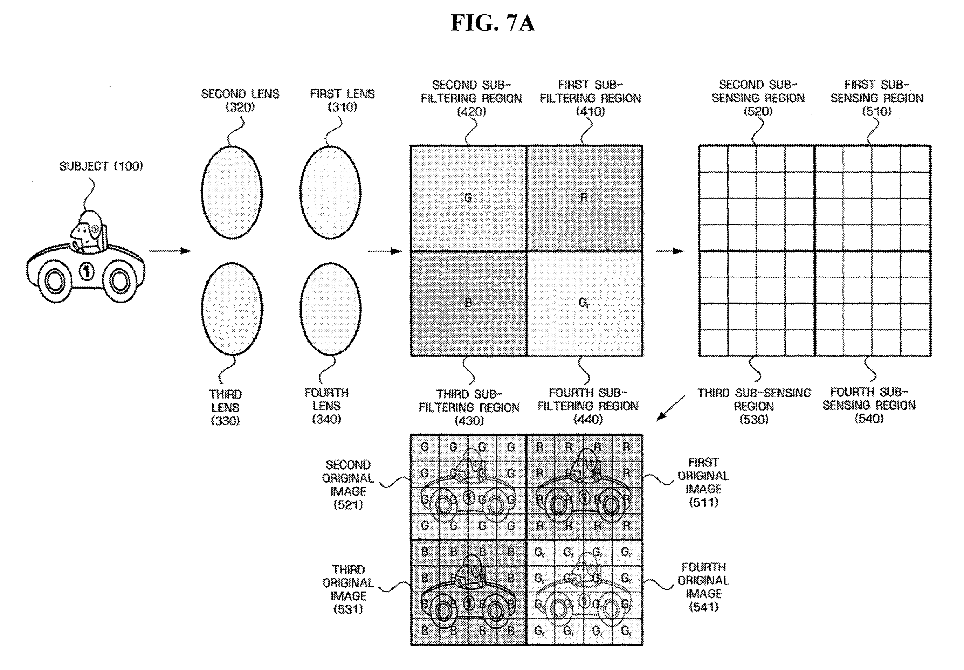

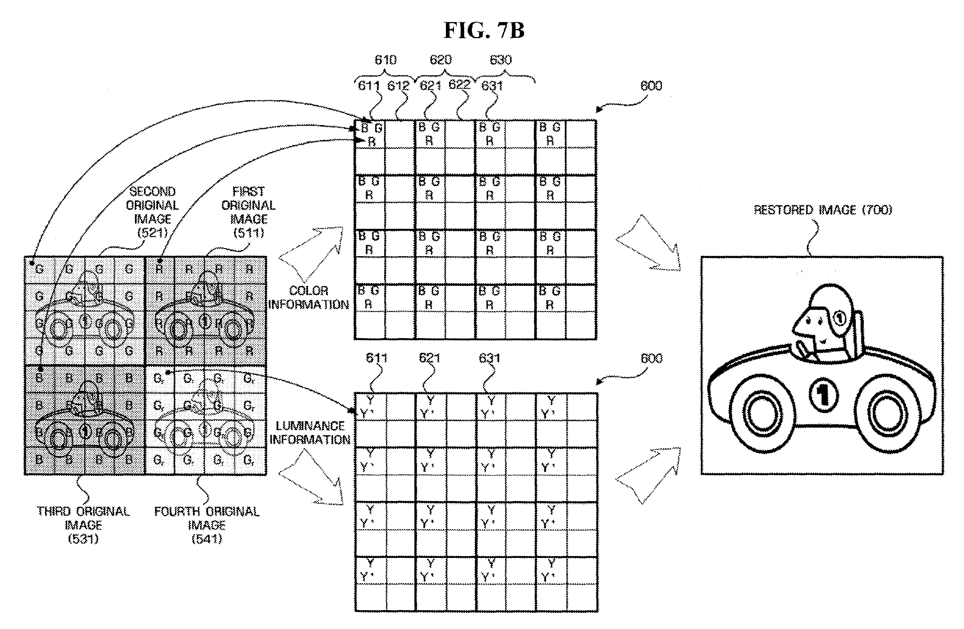

Hereinafter, a method of restoring an image according to an embodiment of the present invention will be described with reference to FIGS. 7A and 7B. FIGS. 7A and 7B are diagrams for explaining a method of restoring an image according to an embodiment of the present invention. Specifically, FIG. 7A illustrates a process of obtaining first through fourth original images 511 through 541 into which a full original image was divided according to color, and FIG. 7B illustrates a process of generating a final image 700 from the original images 511 through 541 into which the full original image was divided according to color.

For convenience of description, it is assumed that the red, green, blue and gray color filters are formed in the first through fourth sub-filtering regions 410 through 440 of the filter unit 400. In addition, it is assumed that the sensing region of the image sensor unit 500 is composed of 8×8 pixels, and each of the first through fourth sub-sensing regions 510 through 540 is composed of 4×4 pixels.

Referring to FIG. 7A, light reflected from a subject 100 is collected by four lenses 310 through 340. The light collected by each of the four lenses 310 through 340 passes through each of the first through fourth sub-filtering regions 410 through 440 corresponding to the lenses 310 through 340, respectively. Then, the light that passed through each of the first through fourth sub-filtering regions 410 through 440 converges on each of the first through fourth sub-sensing regions 510 through 540 corresponding to the first through fourth sub-filtering regions 410 through 440, respectively. As a result, the first through fourth original images 511 through 541 into which the full original image was divided according to color can be obtained from the first through fourth sub-sensing regions 510 through 540, respectively. In this case, the first through fourth original images 511 through 541 obtained from the first through fourth sub-sensing regions 510 through 540, respectively, has a quarter of the resolution of the entire sensing region including the first through fourth sub-sensing regions 510 through 540.

Referring to FIG. 7B, an intermediate image 600 formed in a memory is composed of an equal number of pixels to the number of pixels that constitute the sensing region of the image sensor unit 500. In other words, the intermediate image 600 is composed of 8X8 pixels.

The intermediate image 600 may be divided into first through third pixel groups 610 through 630, each including a plurality of pixels corresponding to the arrangement pattern of a color filter. For example, the intermediate image 600 may be divided into the first through third pixel groups 610 through 630, each including 2X2 pixels. Each of the first through third pixel groups 610 through 630 may be divided into main pixels 611 through 631, to which color information and luminance information are mapped, and sub-pixels 612 and 622 which are located adjacent to the main pixels 611 through 631 and which do not have information.

The position of a main pixel in a corresponding pixel group may vary. For example, in each of the 2x2 first through third pixel groups 610 through 630 illustrated in FIG. 7B, the position of a main pixel may be determined to be a position corresponding to a first column of a first row. In another example, the position of the main pixel in each pixel group may be determined to be a position corresponding to a second column of the first row.

The main pixel in each pixel group has three pieces of color information and two pieces of luminance information. In other words, red color information of the first original image 511, green color information of the second original image 521, and blue color information of the third original image 531, luminance information Y' of the fourth sub-sensing region 540, and luminance information Y obtained based on the red, green and blue color information are mapped to the main pixel of each pixel group. More specifically, red color information of a pixel in a first column of a first row of the first original image 511, green information of a pixel in a first column of a first row of the second original image 521, blue information of a pixel in a first column of a first row of the third original image 531, luminance information of a pixel in a first column of a first row of the fourth original image 540, and luminance information detected based on the red, green and blue color information are mapped to the main pixel 611 of the first pixel group 610. Likewise, red information of a pixel in a second column of the first row of the first original image 511, green information of a pixel in a second column of the first row of the second original image 521, blue information of a pixel in a second column of the first row of the third original image 531, luminance information of a pixel in a second column of the first row of the fourth original image 541, and luminance information detected based on the red, green and blue color information are mapped to the main pixel 621 of the second pixel group 620.

As described above, the information mapped to each of the main pixels 611 through 631 of the first through third pixel groups 610 through 630 is used to restore color information to be recorded in sub-pixels. To restore the color information recorded in each sub-pixel, interpolation may be used. More specifically, information recorded in the sub-pixel 612 between the main pixel 611 of the first pixel group 610 and the main pixel 621 of the second pixel group 620 may be restored based on information retained by the main pixels 611 and 621. Likewise, information recorded in the sub-pixel 622 between the main pixel 621 of the second pixel group 620 and the main pixel 631 of the third pixel group 630 may be restored based on information retained by the main pixels 621 and 631.

Through this restoration process, the (restored) final image 700 having high resolution (that is, the resolution of each of the first through fourth sub-sensing regions 510 through 540x 4) can be obtained from the first through fourth original images 511 through 541, each having low resolution (that is, the resolution of each of the first through fourth sub-sensing regions 510 through 540).

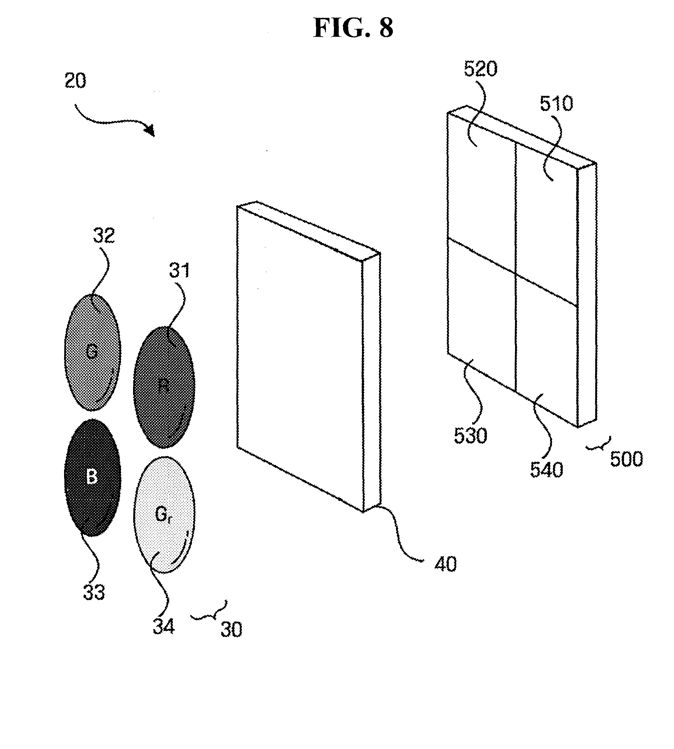

Next, a camera module according to another embodiment of the present invention will be described. FIG. 8 is a perspective view of a camera module 20 according to another embodiment of the present invention. The components of the camera module 20 illustrated in FIG. 8 are identical to those of the camera module illustrated in FIG. 2 except for the following components.

In other words, a lens unit 300 of the camera module 20 includes first through fourth lenses 31 through 34 having different colors. The lens unit 30 may be divided into a first lens group and a second lens group according to transmittance of lenses. Lenses included in the second lens group may have colors with higher transmittances than those included in the first lens group. More specifically, the first through third lenses 31 through 33 included in the first lens group may have red, green and blue colors, and the fourth lens 34 included in the second lens group may have, for example, a gray color which has a higher transmittance than those of the red, green and blue colors.

If the first through fourth lenses 31 through 34 have different colors as described above, an additional color filter layer is not formed in a filter unit 40.

In addition, an image sensor unit is divided into a plurality of sub-sensing regions respectively corresponding to the first through fourth lenses 31 through 34, and images into which a full image was divided according to color by the first through fourth lenses 31 through 34 can be obtained from the sub-sensing regions.

According to the embodiments of the present invention described above, luminance information detected based on color information of first through third original images and luminance information of a fourth original image can be obtained. Therefore, a camera module, which can offer the WDR function without requiring a new processing technology following changes in the structure of an image sensor, can be provided.

As described above, a camera module according to the embodiment of the present invention provides at least one of the following advantages.

First of all, since the camera module uses color filters having different transmittances, high- and low-sensitivity sensing regions can be simultaneously formed in an image sensor unit without requiring a new processing technology.

In addition, since the size of the camera module can be reduced, the degree of freedom with which digital devices, which will have the camera module, can be increased.

A color filter layer and a planarization layer planarizing the color filter layer are not formed in an image sensor. Therefore, the distance between a micro-lens and a photodiode is reduced, and thus an optical loss and crosstalk caused by the thickness of the planarization layer can be reduced.

Since the color filters are not formed on an image sensor but on a separate substrate, a manufacturing process of the image sensor can be simplified. Furthermore, a process of patterning the color filters on the image sensor is omitted, thereby saving ink used to form the color filter layer.

Although a few embodiments of the present invention have been shown and described, it would be appreciated by those skilled in the art that changes may be made in these embodiments without departing from the principles and spirit of the invention, the scope of which is defined in the claims and their equivalents.

## Claims

1. A camera module comprising:
a lens unit comprising a plurality of lenses collecting incident light;
a filter unit having a plurality of filtering regions corresponding to respective regions of the lenses; and
an image sensor unit having a plurality of sensing regions, each converting light that passes through each of the filtering regions into an electrical signal,
wherein the filtering regions are divided into a first filtering region in which different color filters are formed and a second filtering region comprising a color filter having a higher transmittance than the transmittances of the color filters formed in the first filtering region.

2. The camera module of claim 1, wherein the image sensor unit comprises:
a photodiode receiving the light that passes through each of the filtering regions;
an insulation layer formed on the photodiode;
a metal wiring layer formed on the insulation layer and comprising a metal wiring pattern converting the received light into the electrical signal; and
a micro-lens collecting the light that passes through each of the filtering regions and converging the collected light on the photodiode.

3. The camera module of claim 1, wherein the filter unit further comprises an infrared filter filtering infrared light from the light that passes through the lenses.

4. The camera module of claim 3, wherein the filter unit comprises a substrate and the infrared filter and the color filters are sequentially formed on the substrate of the filter unit.

5. The camera module of claim 3, wherein the filter unit comprises a substrate and the color filters are formed on the surface of the substrate of the filter unit, and the infrared filter is formed another surface of the substrate of the filter unit.

6. The camera module of claim 1, wherein the sensing regions are divided into a first sensing region and a second sensing region respectively corresponding to the first filtering region and the second filtering region, and an amount of light converged on sub-sensing regions included in the second sensing region is greater than the amount of light converged on sub-sensing regions included in the first sensing region.

7. The camera module of claim 1, wherein the lenses are coplanar.

8. A camera module comprising:
a lens unit comprising a plurality of lenses having different colors and collecting incident light; and
an image sensor unit having a plurality of sensing regions, each converting light that passes through each of the lenses into an electrical signal.

9. The camera module of claim 8, wherein the image sensor unit comprises:
a photodiode receiving light that passes through each of the lenses;
an insulation layer formed on the photodiode;
a metal wiring layer formed on the insulation layer and comprising a metal wiring pattern converting the received light into the electrical signal; and
a micro-lens collecting the light that passes through each of the lenses and converging the collected light on the photodiode,
wherein the photodiode, the insulation layer, the metal wiring layer, and the micro-lens are sequentially stacked.

10. The camera module of claim 8, further comprising an infrared filter filtering infrared light among light that passes through each of the lenses.

11. The camera module of claim 8, wherein the lenses are divided into a first lens group and a second lens group according to transmittances of the lenses.

12. The camera module of claim 11, wherein the transmittances of lenses included in the first lens group are higher than the transmittances of lenses included in the second lens group.

13. The camera module of claim 12, wherein the sensing regions are divided into a first sensing region and a second sensing region respectively corresponding to the first lens group and the second lens group, and an amount of light converged on sub-sensing regions included in the first sensing region is greater than the amount of light converged on sub-sensing regions included in the second sensing region.

14. The camera module of claim 8, wherein the lenses are coplanar.

15. A camera module comprising:
a filter comprising a first filtering region to filter light, comprising a plurality of filters of different colors, and a second filtering region, having a higher transmittance than the first filtering region, to filter the light; and
an image sensor comprising first and second sensing regions to receive the light respectively filtered by the first and second filtering regions, and convert the received light into respective electrical signals.

16. The camera module of claim 15, wherein the second filtering region comprises a gray filter.

17. A method comprising:
filtering light from an image through a first filtering region comprising passing the light through color filters of different colors;
filtering the light through a second filtering region comprising the passing light through a filter having a higher transmittance than a transmittance of the first filtering region;
forming an intermediate image comprising:
dividing the image into a plurality of pixel groups,
dividing each of the pixel groups into a plurality of pixels comprising a main pixel, and
providing each of the main pixels with color information from each of the color filters, luminance information from the first filtering region, and luminance information from the second filtering region.
